# DEMANDE DE BREVET EUROPEEN

(11) **EP 4 362 067 A1**
(43) Date de publication de la demande: **01.05.2024**
(21) Numéro de dépôt: 23203956.0
(22) Date de dépôt: 17.10.2023
(51) Int. Cl.: H01L 21/20, H01L 29/06, H01L 29/20, H01L 29/267, H01L 29/66, H01L 29/78, H01L 29/861

(54) **PROCEDE DE FABRICATION D'UN DISPOSITIF ELECTRONIQUE DE PUISSANCE, ET DISPOSITIF OBTENU PAR CE PROCEDE**

(30) Priorité: 25.10.2022 FR 2211044
(71) Demandeur: Commissariat à l'énergie atomique et aux énergies alternatives, 75015 Paris (FR)
(72) Inventeur: DUPONT, Florian, 38054 GRENOBLE CEDEX 09 (FR)
(74) Mandataire: Cabinet Beaumont

(57) **Abrégé**

La présente description concerne un procédé de fabrication d'un dispositif électronique de puissance (100) comprenant les étapes successives suivantes :
a) prévoir un substrat semiconducteur en silicium (101), le substrat comportant une face avant (101F) et une face arrière (101R), opposée à la face avant ;
b) former, par croissance épitaxiale depuis la face avant (101F) du substrat (101), une première couche continue (103) en au moins un métal de transition nitruré revêtant la face avant du substrat ; et
c) former, sur la première couche (103), par croissance épitaxiale du côté de la face avant (101F) du substrat (101), au moins une deuxième couche (105, 107, 109) en un matériau III-V, de préférence III-N.

## Description

### Domaine technique

La présente description concerne de façon générale les dispositifs électroniques. La présente description vise plus particulièrement un procédé de fabrication d'un dispositif électronique de puissance à base de nitrure de gallium (GaN), et un dispositif obtenu par ce procédé.

### Technique antérieure

Des dispositifs électroniques de puissance à base de nitrure de gallium ont été proposés. Ces dispositifs et leurs procédés de fabrication souffrent toutefois de divers inconvénients.

### Résumé de l'invention

Un objet d'un mode de réalisation est de pallier tout ou partie des inconvénients des dispositifs électroniques de puissance à base de nitrure de gallium connus.

Pour cela, un mode de réalisation prévoit un procédé de fabrication d'un dispositif électronique de puissance comprenant les étapes successives suivantes :
a) prévoir un substrat semiconducteur en silicium, le substrat comportant une face avant et une face arrière, opposée à la face avant ;
b) former, par croissance épitaxiale depuis la face avant du substrat, une première couche continue en au moins un métal de transition nitruré revêtant la face avant du substrat ; et
c) former, sur la première couche, par croissance épitaxiale du côté de la face avant du substrat, au moins une deuxième couche en un matériau III-V, de préférence III-N.

Selon un mode de réalisation, la première couche continue est en un métal de transition nitruré ou un alliage de métaux de transition nitrurés choisis parmi le nitrure de titane, le nitrure de vanadium, le nitrure de chrome, le nitrure de zirconium, le nitrure de niobium, le nitrure de molybdène, le nitrure d'hafnium et le nitrure de tantale.

Selon un mode de réalisation, le procédé comprend en outre, entre les étapes b) et c), une étape de formation, par ablation laser pulsée depuis une face de la première couche opposée à la face avant du substrat, d'une troisième couche épitaxiale en un matériau choisi parmi le nitrure d'aluminium, le nitrure de gallium, le nitrure d'indium et les alliages de ces matériaux, la troisième couche revêtant ladite face de la première couche.

Selon un mode de réalisation, le procédé comprend en outre, entre les étapes b) et c), une étape de gravure de la première couche et du substrat.

Selon un mode de réalisation, le procédé comprend en outre, entre les étapes a) et b), une étape de gravure du substrat.

Selon un mode de réalisation, le procédé comprend en outre, après l'étape c), une étape de formation d'une première électrode de conduction du dispositif, revêtant une face de ladite au moins une deuxième couche opposée à la face avant du substrat, et d'une deuxième électrode de conduction du dispositif, revêtant la face arrière du substrat.

Selon un mode de réalisation, le substrat semiconducteur est sensiblement monocristallin, la face avant du substrat présentant une orientation cristalline (111).

Selon un mode de réalisation, à l'étape b), la première couche continue est formée par ablation laser pulsée.

Selon un mode de réalisation, le procédé comprend en outre, entre les étapes b) et c), une étape de formation d'un masque de croissance sélective.

Un mode de réalisation prévoit un dispositif électronique de puissance comprenant :
- un substrat semiconducteur en silicium, le substrat comportant une face avant et une face arrière, opposée à la face avant ;
- une première couche épitaxiale continue en au moins un métal de transition nitruré revêtant la face avant du substrat ; et
- au moins une deuxième couche épitaxiale continue en un matériau III-V, de préférence III-N, située sur la première couche.

Selon un mode de réalisation, le dispositif comprend en outre une première électrode de conduction, revêtant une face de ladite au moins une deuxième couche opposée à la face avant du substrat, et une deuxième électrode de conduction, revêtant la face arrière du substrat.

Selon un mode de réalisation, les première et deuxième électrodes sont respectivement des électrodes d'anode et de cathode, le dispositif étant de type diode.

Selon un mode de réalisation, le substrat comprend une première partie, située à l'aplomb de l'électrode d'anode, présentant une épaisseur supérieure à celle d'une deuxième partie du substrat de forme annulaire entourant la première partie.

Selon un mode de réalisation, le dispositif comprend en outre une troisième couche continue en un matériau choisi parmi le nitrure d'aluminium, le nitrure de gallium et le nitrure d'indium la troisième couche revêtant ladite face de la première couche.

Selon un mode de réalisation, le dispositif comprend en outre une électrode de commande pénétrant à l'intérieur de ladite au moins une deuxième couche, le dispositif étant de type transistor.

Selon un mode de réalisation, les flancs de ladite au moins une deuxième couche sont revêtus d'une couche de passivation.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe illustrant, de façon schématique et partielle, un exemple d'un dispositif électronique de puissance selon un mode de réalisation ;

les figure 2A, figure 2B et figure 2C sont des vues en coupe illustrant, de façon schématique et partielle, des étapes successives d'un exemple de procédé de fabrication du dispositif de la figure 1 ;

la figure 3 est une vue en coupe illustrant, de façon schématique et partielle, un exemple d'un dispositif électronique de puissance selon un mode de réalisation ;

la figure 4 est une vue en coupe illustrant, de façon schématique et partielle, un exemple d'un dispositif électronique de puissance selon un mode de réalisation ; et

la figure 5 est une vue en coupe illustrant, de façon schématique et partielle, un exemple d'un dispositif électronique de puissance selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation complète des dispositifs de puissance, notamment de leurs éventuels circuits de contrôle, n'a pas été détaillée, la réalisation de ces dispositifs étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

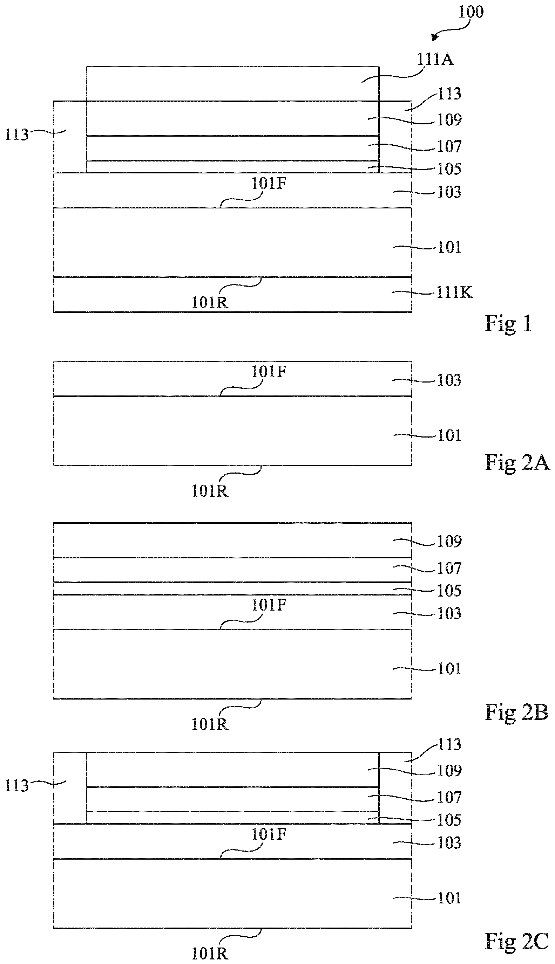

La figure 1 est une vue en coupe illustrant, de façon schématique et partielle, un exemple d'un dispositif électronique de puissance 100 selon un mode de réalisation.

Le dispositif 100 de la figure 1 est plus précisément de type diode, par exemple une diode de puissance susceptible d'être utilisée dans des applications mettant en oeuvre des puissances typiquement comprises entre quelques milliwatts et plusieurs dizaines de watts, par exemple des applications de conversion d'énergie électrique. Les modes de réalisation décrits sont particulièrement avantageux pour la réalisation de composants électroniques de puissance présentant une tension de claquage élevée, par exemple supérieure à 450 V.

Le dispositif 100 de la figure 1 est par exemple un composant discret commandable individuellement et présentant, vu de dessus, une surface comprise par exemple entre quelques micromètres carrés et quelques millimètres carrés.

Dans l'exemple représenté, le dispositif 100 comprend un substrat de support 101 en un matériau semiconducteur, par exemple le silicium (Si). Le substrat de support 101 est par exemple une plaquette ou un morceau de plaquette en silicium sensiblement monocristallin. Le matériau du substrat 101 est par exemple fortement dopé d'un premier type de conductivité, par exemple le type n (dopage n+). À titre d'exemple, le substrat 101 présente un niveau de dopage compris entre 1 x 10¹⁷ at./cm³ et 5 x 10²⁰ at./cm³.

Dans l'exemple illustré, une couche continue 103 en un métal de transition nitruré revêt une face 101F, appelée « face avant », du substrat 101 (la face supérieure du substrat 101, dans l'orientation de la figure 1). Dans le cas où le substrat de support 101 est une plaquette ou un morceau de plaquette en silicium monocristallin, la face avant 101F correspond par exemple à un plan cristallin (111) du cristal, le substrat étant alors orienté (111). Dans l'exemple représenté, la couche 103 s'étend latéralement sur et en contact avec la face avant 101F du substrat 101. À titre d'exemple, la couche 103 présente une épaisseur comprise entre 0,5 nm et 100 nm, par exemple égale à environ 20 nm.

À titre d'exemple, le métal de transition nitruré de la couche 103 est choisi parmi le nitrure de titane (TiN), le nitrure de vanadium (VN), le nitrure de chrome (CrN), le nitrure de zirconium (ZrN), le nitrure de niobium (NbN), le nitrure de molybdène (MoN), le nitrure d'hafnium (HfN) et le nitrure de tantale (TaN). Le métal de transition nitruré est par exemple un mononitrure. La présente description ne se limite toutefois pas à ce cas, le métal de transition nitruré pouvant, à titre de variante, présenter une stoechiométrie différente de celle d'un mononitrure (par exemple Ta₂N, Ta₅N₆ ou Ta₃N₅, pour le nitrure de tantale). Par ailleurs, la structure cristalline du métal de transition nitruré de la couche 103 est, dans le cas d'un composé polymorphe, choisie parmi les différentes structures, ou formes, connues pour ce composé (par exemple les formes α et ε, pour le mononitrure de tantale) de sorte à faciliter la compatibilité cristalline avec le matériau du substrat 101. À titre de variante, la couche 103 est en un alliage d'au moins deux métaux de transition nitrurés, par exemple un alliage Ta_{0,5}Ti_{0,5}N.

Par ailleurs, la couche continue 103 peut présenter une structure monocouche ou multicouche. Dans le cas d'une structure multicouche, la couche 103 comprend par exemple un empilement d'au moins deux couches en des matériaux différents, chaque couche étant en un métal de transition nitruré ou en un alliage de métaux de transition nitrurés.

Le métal de transition nitruré de la couche 103 est par exemple un nitrure métallique électriquement conducteur. Dans ce cas, la couche 103 est électriquement conductrice.

Selon un mode de réalisation, le dispositif 100 comprend en outre au moins une couche continue en nitrure de gallium (GaN) située sur la couche 103 en métal de transition nitruré. Dans l'exemple illustré en figure 1, le dispositif 100 comprend plus particulièrement une couche 105 continue en nitrure de gallium fortement dopé du premier type de conductivité (dopage n+, dans cet exemple) revêtant une partie de la face de la couche 103 en métal de transition nitruré opposée au substrat 101 (la face supérieure de la couche 103, dans l'orientation de la figure 1). Dans cet exemple, la couche 105 est revêtue, sur sa face opposée au substrat 101 (la face supérieure de la couche 105, dans l'orientation de la figure 1), d'une autre couche 107 en nitrure de gallium faiblement dopé du premier type de conductivité (dopage n-, dans cet exemple) elle-même revêtue, sur sa face opposée au substrat 101 (la face supérieure de la couche 107, dans l'orientation de la figure 1), d'encore une autre couche 109 en nitrure de gallium faiblement dopé d'un deuxième type de conductivité (dopage p-, dans cet exemple), opposé au premier type de conductivité.

À titre d'exemple, la couche 105 présente un niveau de dopage compris entre 1 x 10¹⁷ at./cm³ et 5 x 10²⁰ at./cm³ et les couches 107 et 109 présentent chacune un niveau de dopage inférieur à celui de la couche 105, par exemple compris entre 1 x 10¹⁰ at./cm³ et 1 x 10¹⁷ at./cm³. Les niveaux de dopage des couches 107 et 109 sont par exemple sensiblement égaux.

Selon un mode de réalisation, la couche en métal de transition nitruré et la ou les couches en nitrure de gallium situées du côté de la face avant du substrat sont des couches épitaxiales, c'est-à-dire formées par croissance épitaxiale, ou épitaxie. Dans l'exemple représenté, les couches 103, 105, 107 et 109 résultent de la mise en oeuvre d'étapes d'épitaxie successives depuis la face avant 101F du substrat 101. Dit autrement, les couches déposées présentent une continuité latérale (c'est-à-dire dans le plan horizontal, dans l'orientation de la figure 1) de la structure cristalline, ou un alignement cristallin vertical entre les différentes couches déposées. Ainsi, le substrat 101 et les couches 103, 105, 107 et 109 présentent des structures cristallines comportant des éléments de symétrie communs et des paramètres de maille semblables. La structure cristalline de chaque couche 103, 105, 107, 109 est organisée par rapport à la structure cristalline, et en particulier par rapport au plan cristallin de la face supérieure, du substrat sous-jacent, dans le cas de la couche 103, ou de la couche 103, 105, 107 sous-jacente, dans le cas des couches 105, 107 et 109, respectivement.

La couche 103 en métal de transition nitruré permet de réaliser une adaptation de paramètre de maille entre le substrat 101 et la couche 105.

Dans l'exemple représenté, le dispositif 100 comporte en outre des électrodes disposées de part et d'autre de la structure formée par le substrat 101 et les couches 103, 105, 107 et 109. Le dispositif 100 comprend plus précisément une électrode d'anode 111A revêtant la face de la couche 109 en nitrure de gallium opposée au substrat 101 (la face supérieure de la couche 109, dans l'orientation de la figure 1) et une électrode de cathode 111K revêtant une face 101R du substrat 101 opposée à sa face avant 101F. La face 101R, appelée « face arrière » du substrat 101, correspond, dans l'orientation de la figure 1, à la face inférieure du substrat 101. À titre d'exemple, les électrodes 111A et 111K sont en un matériau électriquement conducteur, par exemple un métal ou un alliage métallique.

Dans l'exemple illustré en figure 1, les flancs des couches en nitrure de gallium 105, 107 et 109 sont revêtus d'une couche de passivation 113. La couche de passivation 113 permet de préserver les couches 105, 107 et 109 de l'oxydation. À titre d'exemple, la couche de passivation 113 est en nitrure de silicium (SiNₓ), en dioxyde de silicium, en verre déposé par centrifugation (« Spin-On Glass » - SOG, en anglais) ou en oxyde de tantale (TaOₓ).

Les figure 2A, figure 2B et figure 2C sont des vues en coupe illustrant, de façon schématique et partielle, des étapes successives d'un exemple de procédé de fabrication du dispositif 100 de la figure 1.

La figure 2A illustre plus précisément une structure obtenue à l'issue d'une étape de formation, par hétéroépitaxie depuis la face avant 101F du substrat 101, de la couche 103 en métal de transition nitruré.

La couche 103 est par exemple formée par dépôt PLD (de l'anglais « Pulsed Laser Déposition » - ablation laser pulsée), aussi appelé dépôt par ablation laser pulsée. Le dépôt PLD consiste à ablater la surface d'une cible du matériau à déposer au moyen d'un laser pulsé, de manière à transférer le matériau dans un plasma, puis, via le plasma, sur le substrat de destination. À titre d'exemple, le substrat 101 est, lors du dépôt PLD de la couche 103, chauffé à une température comprise entre 400 °C et 1 000 °C, par exemple égale à environ 700 °C.

Un avantage du dépôt PLD est qu'il peut permettre de déposer des matériaux complexes avec une bonne qualité cristalline, et ce à une température relativement basse, par exemple de l'ordre de 700 °C, sans endommager le substrat de destination. Un autre avantage du dépôt PLD est qu'il peut permettre d'épitaxier les matériaux déposés.

À titre de variante, la couche 103 en métal de transition nitruré est formée par une autre méthode de dépôt physique en phase vapeur (« Physical Vapor Déposition » - PVD, en anglais), par exemple par évaporation ou par pulvérisation.

L'étape de formation de la couche 103 peut être suivie d'une étape de désoxydation de la face supérieure de cette couche, par exemple à l'acide fluorhydrique (HF), de sorte à faciliter la réalisation des étapes ultérieures du procédé.

La figure 2B illustre plus précisément une structure obtenue à l'issue d'une étape de formation des couches en nitrure de gallium 105, 107 et 109 sur la couche 103 en métal de transition nitruré. Les couches 105, 107 et 109 sont successivement épitaxiées depuis la face supérieure de la couche 103, par exemple par MOCVD (de l'anglais « Metal-Organic Chemical Vapor Déposition » - dépôt chimique en phase vapeur de type métal-organique). Plus précisément, la couche 105 en nitrure de gallium est formée, par hétéroépitaxie, depuis la face supérieure de la couche 103 en métal de transition nitruré et les couches 107 et 109 en nitrure de gallium sont ensuite formées, par homoépitaxie, depuis les faces supérieures des couches 105 et 107, respectivement.

En pratique, la couche 103 en métal de transition nitruré est par exemple d'abord formée, sous vide, dans un premier réacteur. La structure illustrée en figure 2A est par exemple ensuite transférée dans un deuxième réacteur. Les couches 105, 107 et 109 en nitrure de gallium sont alors formées, sous vide, dans le deuxième réacteur. À titre de variante, la couche 105 peut être formée par dépôt PLD dans le premier réacteur, les couches 107 et 109 étant ensuite formées par MOCVD dans le deuxième réacteur. De façon optionnelle, une autre couche en nitrure de gallium ou en nitrure d'aluminium-gallium peut, dans cette variante, être déposée par MOCVD dans le deuxième réacteur après dépôt PLD de la couche 105 dans le premier réacteur. Cela permet d'éviter une exposition à l'air de la couche 103. Cela peut en outre faciliter une reprise d'épitaxie lors du dépôt MOCVD.

La figure 2C illustre plus précisément une structure obtenue à l'issue d'une étape de structuration des couches 105, 107 et 109 en nitrure de gallium et de dépôt de la couche de passivation 113. Les couches 105, 107 et 109 sont par exemple structurées par photolithographie puis gravure.

La couche de passivation 113 est par exemple ensuite déposée sur la structure du côté de la face avant 101F du substrat 101, puis amincie, par exemple par polissage mécano-chimique (« Chemical-Mechanical Polishing » - CMP, en anglais), de sorte à exposer la face supérieure de la couche 109 en nitrure de gallium. À l'issue de ces étapes, la couche de passivation 113 revêt les flancs des couches 105, 107 et 109 en nitrure de gallium et la face supérieure de la couche 103 en métal de transition nitruré. Dans l'exemple représenté, la couche de passivation 113 affleure la face supérieure de la couche 109 en nitrure de gallium.

À partir de la structure illustrée en figure 2C, les électrodes d'anode 111A et de cathode 111K du dispositif 100 peuvent alors être formées sur la face supérieure de la couche 109 en nitrure de gallium et sur la face arrière 101R du substrat 101, respectivement.

À titre de variante, la couche de passivation 113 peut être déposée puis amincie après formation des électrodes 111A et 111K du dispositif 100.

Un avantage du procédé décrit ci-dessus en relation avec la figure 1 tient au fait qu'il est moins coûteux et plus simple à mettre en oeuvre que les procédés actuels de fabrication de dispositifs électroniques de puissance à base de nitrure de gallium, par exemple les procédés visant à former une électrode de conduction sur une couche de GaN fortement dopée, les procédés comprenant des étapes de retrait du substrat de support et de report de l'empilement comprenant les couches de GaN sur un autre substrat, les procédés de formation d'un ou plusieurs vias à travers le substrat de support et de dépôt conforme d'une électrode dans chacun de ces vias, et les procédés de reprise de contact depuis la face arrière du substrat dans lesquels une couche tampon, typiquement en nitrure d'aluminium, est interposée entre la face avant du substrat de support et l'empilement comprenant les couches de GaN.

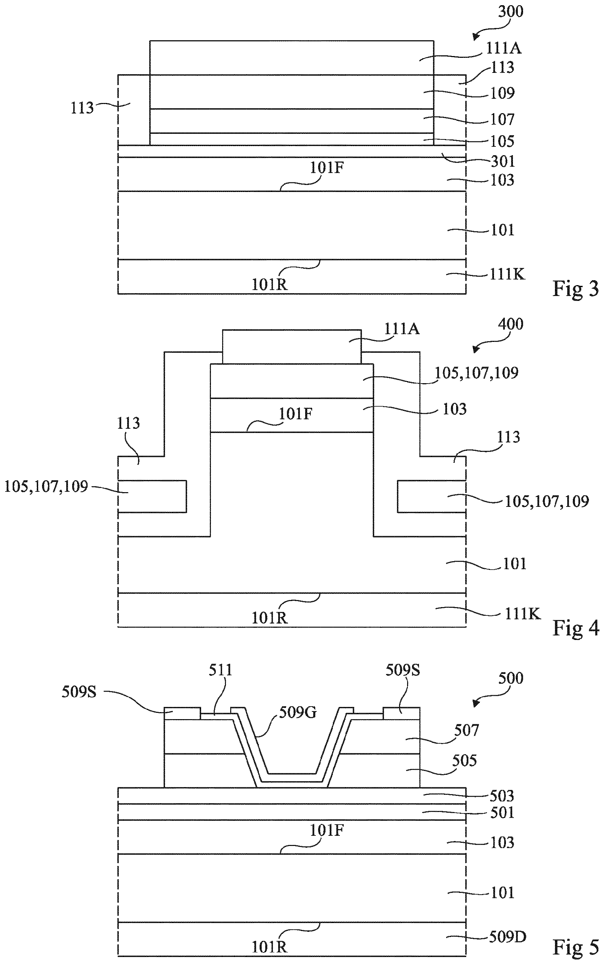

La figure 3 est une vue en coupe illustrant, de façon schématique et partielle, un exemple d'un dispositif électronique de puissance 300 selon un mode de réalisation. Le dispositif 300 de la figure 3 comprend des éléments communs avec le dispositif 100 de la figure 1. Ces éléments communs ne seront pas détaillés à nouveau ci-après.

Le dispositif 300 de la figure 3 diffère du dispositif 100 de la figure 1 en ce qu'il comporte une couche 301 interposée entre la couche 103 en métal de transition nitruré et la couche 105 en nitrure de gallium. Le matériau de la couche 301 est par exemple un matériau semiconducteur inorganique, par exemple un composé III-V comprenant au moins un premier élément du groupe III, un deuxième élément du groupe V et, éventuellement, un troisième élément, par exemple un élément du groupe III autre que le premier élément. De façon préférentielle, l'élément du groupe V est l'azote (N), de sorte que le matériau de la couche 301 est un composé III-N. À titre d'exemple, le matériau de la couche 301 est le nitrure de gallium (GaN), le nitrure d'aluminium (AlN), le nitrure de bore (BN), le nitrure d'indium (InN) ou un alliage d'un ou plusieurs de ces matériaux, par exemple le nitrure d'aluminium-gallium (AlGaN). L'épaisseur de la couche 301 est choisie de façon à permettre un passage de courant, par effet tunnel, entre la couche 105 en nitrure de gallium et la couche 103 en métal de transition nitruré. À titre d'exemple, la couche 301 présente une épaisseur inférieure à 5 nm, par exemple comprise entre 1 et 2 nm, par exemple égale à environ 1 nm.

Le matériau de la couche 301 du dispositif 300 peut être fortement dopé du premier type de conductivité (le type n, dans cet exemple). Dans le cas où la couche 301 est en nitrure de gallium, le silicium (Si) peut être utilisé pour obtenir un fort dopage de type n (dopage n++). À titre d'exemple, la couche 301 présente un niveau de dopage compris entre 1 x 10¹⁷ at./cm³ et 5 x 10²¹ at./cm³, par exemple égal à environ 1 x 10²⁰ at./cm³.

À titre d'exemple, la couche 301 est formée, par exemple par PLD, entre les étapes précédemment décrites en relation avec les figures 2A et 2B. Dans le cas où la couche 301 est en nitrure de gallium fortement dopé de type n par des atomes de silicium, une cible GaN:Si peut être utilisée lors du dépôt PLD.

Dans l'exemple représenté, la couche 301 est laissée intacte à l'issue de l'étape de structuration des couches 105, 107 et 109 en nitrure de gallium précédemment décrite en relation avec la figure 2C. À titre de variante, la couche 301 pourrait être structurée de façon analogue aux couches 105, 107 et 109 lors de l'étape de la figure 2C.

Un avantage du dispositif 300 tient au fait que la couche 301 peut permettre un contrôle de polarité de la couche 103 en métal de transition nitruré. La couche 301 permet en outre de protéger la couche 103 contre l'oxydation.

La figure 4 est une vue en coupe illustrant, de façon schématique et partielle, un exemple d'un dispositif électronique de puissance 400 selon un mode de réalisation. Le dispositif 400 de la figure 4 comprend des éléments communs avec le dispositif 100 de la figure 1. Ces éléments communs ne seront pas détaillés à nouveau ci-après.

Le dispositif 400 de la figure 4 diffère du dispositif 100 de la figure 1 en ce que le substrat 101 comprend une première partie, située à l'aplomb de l'électrode d'anode 111A, présentant une épaisseur (distance entre les faces avant 101F et arrière 101R du substrat 101) supérieure à celle d'une deuxième partie du substrat 101 de forme annulaire entourant la première partie.

Les différences d'épaisseur entre les première et deuxième parties du substrat 101 sont par exemple obtenues par structuration du substrat 101 préalablement au dépôt des couches 105, 107 et 109 en nitrure de gallium. Afin de ne pas surcharger le dessin, les couches 105, 107 et 109 ont été symbolisées par une unique couche en figure 4.

Dans l'exemple représenté, la couche 103 en métal de transition nitruré revêt uniquement la face avant 101F de la première partie du substrat 101. À titre d'exemple, la couche 103 est d'abord formée sur toute la face avant 101F du substrat 101, puis le substrat 101 et la couche 103 sont structurés, par exemple par photolithographie puis gravure, préalablement au dépôt des couches 105, 107 et 109 en nitrure de gallium. À titre de variante, la couche 103 en métal de transition nitruré peut être déposée sur toute la face avant 101F du substrat 101 postérieurement à la structuration du substrat 101.

Dans l'exemple représenté, l'empilement constitué par les couches 105, 107 et 109 en nitrure de gallium est discontinu et présente plus précisément une première partie située à l'aplomb de l'électrode 111A d'anode et une deuxième partie de forme annulaire entourant la première partie. Dans un cas où le substrat 101 et l'empilement constitué par les couches 105, 107 et 109 présentent une forte différence de coefficient de dilatation thermique, par exemple lorsque le substrat 101 est en silicium, cela permet avantageusement d'éviter ou de limiter l'apparition de défauts, tels que des discontinuités ou fissures, dans les couches 105, 107 et 109 en nitrure de gallium.

Selon un autre exemple de réalisation, la couche 103 est d'abord déposée par ablation laser pulsée sur la face supérieure 101F du substrat 101 en silicium. Dans cet exemple, le substrat 101 présente par exemple une face supérieure 101F sensiblement plane et la couche 103 est continue. Une couche par exemple en nitrure de silicium (Si₃N₄), en dioxyde de silicium ou en alumine est ensuite déposée sur et en contact avec la face supérieure de la couche 103 puis structurée, par exemple par photolithographie puis gravure, de sorte à former un masque de croissance comprenant des ouvertures traversantes au fond desquelles sont exposées des parties de la face supérieure de la couche 103 sous-jacente. Une croissance sélective par MOCVD est ensuite mise en oeuvre de sorte à former des plots en nitrure de gallium, par exemple des plots comprenant chacun un empilement de couches en nitrure de gallium analogues aux couches 105, 107 et 109, à l'intérieur des ouvertures du masque de croissance. À titre de variante, un empilement comprenant les couches 103 et 105 peut être déposé par PLD avant la formation du masque de croissance. Cela permet là encore d'éviter ou de limiter l'apparition de fissures dans les couches en nitrure de gallium.

La figure 5 est une vue en coupe illustrant, de façon schématique et partielle, un exemple d'un dispositif électronique de puissance 500 selon un mode de réalisation.

Le dispositif 500 de la figure 5 est plus précisément de type transistor, par exemple un transistor de puissance destiné à autoriser ou à empêcher le passage d'un courant électrique entre ses bornes de conduction.

Le dispositif 500 de la figure 5 comprend des éléments communs avec le dispositif 100 de la figure 1. Ces éléments communs ne seront pas détaillés à nouveau ci-après.

Le dispositif 500 comporte en particulier le substrat 101 dopé du premier type de conductivité (le type n, dans cet exemple) dont la face avant 101F est revêtue de la couche 103 en métal de transition nitruré. Le dispositif 500 de la figure 5 diffère du dispositif 100 de la figure 1 en ce que le dispositif 500 comprend un empilement vertical comportant, dans l'ordre à partir de la face supérieure de la couche 103, une première couche continue 501 en GaN dopé du premier type de conductivité (le type n, dans cet exemple), une deuxième couche continue 503 en GaN non intentionnellement dopé, une troisième couche continue 505 en GaN dopé du deuxième type de conductivité (le type p, dans cet exemple) et une quatrième couche continue 507 en GaN dopé du premier type de conductivité (le type n, dans cet exemple).

Dans l'exemple représenté, la couche 501 revêt la face supérieure de la couche 103 et la couche 503 revêt la face supérieure de la couche 501. Par ailleurs, la couche 505 revêt une partie de la face supérieure de la couche 503 et la couche 507 revêt la face supérieure de la couche 505.

Le dispositif 500 comprend en outre une électrode de grille 509G, s'étendant verticalement dans l'épaisseur des couches 505 et 507 depuis la face supérieure de la couche 507, des électrodes de source 509S, situées sur et en contact avec la face supérieure de la couche 507 de part et d'autre de l'électrode de grille 509G, et une électrode de drain 509D revêtant la face arrière 101R du substrat 101.

Dans l'exemple représenté, le dispositif 500 comprend en outre une couche électriquement isolante 511, par exemple en alumine (Al₂O₃), interposée entre l'électrode de grille 509G, d'une part, et les couches 505 et 507 en GaN, d'autre part. La couche 511 isole l'électrode 509G des couches 505 et 507. Dans l'exemple illustré en figure 5, l'électrode de grille 509G et la couche 511 forment une région de grille traversant les couches 505 et 507 et s'interrompant sur la face supérieure de la couche 503. Cet exemple n'est toutefois pas limitatif, la région de grille formée par l'électrode 509G et la couche 511 pouvant pénétrer dans l'empilement constitué par les couches 501, 503, 505 et 507 jusqu'à une profondeur différente de celle illustrée en figure 5.

Dans l'exemple représenté, la couche isolante 511 se prolonge latéralement, sous l'électrode 509G et sur et en contact avec la face supérieure de la couche 507, jusqu'aux flancs des électrodes de source 509S.

Bien que cela n'ait pas été illustré en figure 5, une couche de passivation, par exemple une couche analogue à la couche 113 des figures 1, 3 et 4, peut revêtir les flancs des couches 505 et 507 en nitrure de gallium du dispositif 500.

Les dispositifs de puissance 100, 300, 400 et 500 des figures 1, 3, 4 et 5 présentent chacun une architecture dite « verticale », dans laquelle les électrodes de conduction (anode 111A et cathode 111K, pour les dispositifs 100, 300 et 400, et source 509S et drain 509D, pour le dispositif 500) sont situées de part et d'autre de l'empilement comprenant le substrat 101 et les couches en nitrure de gallium. Cela permet avantageusement, notamment par rapport à des dispositifs de puissance présentant une structure dite « latérale », dans laquelle les électrodes de conduction sont situées d'un même côté du substrat, d'obtenir des tensions de claquage plus élevées.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que des structures et des procédés de fabrication de diodes et de transistor aient été détaillés ci-dessus en relation avec les figures 1 à 5, les modes de réalisation décrits s'appliquent à d'autres types de composants de puissance présentant une architecture verticale.

Bien que les couches 105, 107, 109, 501, 503, 505 et 507 soient en nitrure de gallium dans les exemples de réalisation détaillés ci-dessus, la personne du métier est plus généralement capable de prévoir que ces couches soient en un matériau III-V quelconque, de préférence un matériau III-N.

Par ailleurs, la personne du métier est capable, à partir des indications ci-dessus, d'adapter le procédé de fabrication du dispositif 100 décrit en relation avec les figures 2A à 2C pour réaliser les dispositifs 300, 400 et 500.

Enfin, la mise en oeuvre pratique des modes de réalisation et variantes décrits est à la portée de la personne du métier à partir des indications fonctionnelles données ci-dessus. En particulier, bien que l'on ait décrit ci-dessus des modes de réalisation dans lesquels le premier type de conductivité est n et le deuxième type de conductivité est p, la personne du métier est capable de transposer les modes de réalisation de la présente description au cas où les types de conductivité sont inversés.

## Revendications

1. Procédé de fabrication d'un dispositif électronique de puissance (100 ; 300 ; 400 ; 500) comprenant les étapes successives suivantes :
a) prévoir un substrat semiconducteur en silicium (101), le substrat comportant une face avant (101F) et une face arrière (101R), opposée à la face avant ;
b) former, par croissance épitaxiale depuis la face avant (101F) du substrat (101), une première couche continue (103) en au moins un métal de transition nitruré revêtant la face avant du substrat ; et
c) former, sur la première couche (103), par croissance épitaxiale du côté de la face avant (101F) du substrat (101), au moins une deuxième couche (105, 107, 109 ; 501, 503, 505, 507) en un matériau III-V, de préférence III-N,
dans lequel la première couche (103) est en nitrure de titane et s'étend latéralement sur et en contact avec la face avant (101F) du substrat (101).

2. Procédé selon la revendication 1, comprenant en outre, entre les étapes b) et c), une étape de formation, par ablation laser pulsée depuis une face de la première couche (103) opposée à la face avant (101F) du substrat (101), d'une troisième couche (301) épitaxiale en un matériau choisi parmi le nitrure d'aluminium, le nitrure de gallium, le nitrure d'indium et les alliages de ces matériaux, la troisième couche (301) revêtant ladite face de la première couche (103).

3. Procédé selon la revendication 1 ou 2, comprenant en outre, entre les étapes b) et c), une étape de gravure de la première couche (103) et du substrat (101).

4. Procédé selon la revendication 1 ou 2, comprenant en outre, entre les étapes a) et b), une étape de gravure du substrat (101) .

5. Procédé selon l'une quelconque des revendications 1 à 4, comprenant en outre, après l'étape c), une étape de formation d'une première électrode de conduction (111A ; 509S) du dispositif, revêtant une face de ladite au moins une deuxième couche (109 ; 507) opposée à la face avant (101F) du substrat (101), et d'une deuxième électrode de conduction (111K ; 509D) du dispositif, revêtant la face arrière (101R) du substrat (101).

6. Procédé selon l'une quelconque des revendications 1 à 5, dans lequel le substrat semiconducteur (101) est sensiblement monocristallin, la face avant (101F) du substrat présentant une orientation cristalline (111).

7. Procédé selon l'une quelconque des revendications 1 à 6, dans lequel, à l'étape b), la première couche continue (103) est formée par ablation laser pulsée.

8. Procédé selon l'une quelconque des revendications 1 à 7, comprenant en outre, entre les étapes b) et c), une étape de formation d'un masque de croissance sélective.

9. Dispositif électronique de puissance (100 ; 300 ; 400 ; 500) comprenant :
- un substrat semiconducteur en silicium (101), le substrat comportant une face avant (101F) et une face arrière (101R), opposée à la face avant ;
- une première couche épitaxiale continue (103) en au moins un métal de transition nitruré revêtant la face avant (101F) du substrat (101) ; et
- au moins une deuxième couche épitaxiale continue (105, 107, 109 ; 501, 503, 505, 507) en un matériau III-V, de préférence III-N, située sur la première couche,
dans lequel la première couche (103) est en nitrure de titane et s'étend latéralement sur et en contact avec la face avant (101F) du substrat (101).

10. Dispositif selon la revendication 9, comprenant en outre une première électrode de conduction (111A ; 509S), revêtant une face de ladite au moins une deuxième couche (109 ; 507) opposée à la face avant (101F) du substrat (101), et une deuxième électrode de conduction (111K ; 509D), revêtant la face arrière (101R) du substrat (101).

11. Dispositif (100 ; 300 ; 400) selon la revendication 10, dans lequel les première et deuxième électrodes (111A, 111K) sont respectivement des électrodes d'anode et de cathode, le dispositif étant de type diode.

12. Dispositif selon la revendication 11, dans lequel le substrat (101) comprend une première partie, située à l'aplomb de l'électrode d'anode (111A), présentant une épaisseur supérieure à celle d'une deuxième partie du substrat (101) de forme annulaire entourant la première partie.

13. Dispositif selon l'une quelconque des revendications 9 à 12, comprenant en outre une troisième couche continue (301) en un matériau choisi parmi le nitrure d'aluminium, le nitrure de gallium et le nitrure d'indium la troisième couche (301) revêtant ladite face de la première couche (103) .

14. Dispositif (500) selon la revendication 10, comprenant en outre une électrode de commande (509G) pénétrant à l'intérieur de ladite au moins une deuxième couche (501, 503, 505, 507), le dispositif étant de type transistor.

15. Dispositif selon l'une quelconque des revendications 9 à 14, dans lequel les flancs de ladite au moins une deuxième couche (105, 107, 109 ; 501, 503, 505, 507) sont revêtus d'une couche de passivation (113).
